**Europäisches Patentamt**

**European Patent Office**

**Office européen des brevets**

(19)

(11) Numéro de publication: **0 201 401**
**A1**

# (12) DEMANDE DE BREVET EUROPEEN

(21) Numéro de dépôt: **86400888.3**

(22) Date de dépôt: **23.04.86**

(51) Int. Cl.⁴: **H 03 M 3/04**

(30) Priorité: **24.04.85 FR 8506256**

(43) Date de publication de la demande: **12.11.86**
**Bulletin 86/46**

(84) Etats contractants désignés: **DE GB IT**

(71) Demandeur: **le Guyader, Alain, 40 résidence du Roux,
F-22300 Lannion (FR)**

(72) Inventeur: **le Guyader, Alain, 40 résidence du Roux,
F-22300 Lannion (FR)**

(74) Mandataire: **Fort, Jacques et al, CABINET
PLASSERAUD 84, rue d'Amsterdam, F-75009 Paris (FR)**

(54) **Procédé de codage MIC différentiel et installation de transmission d'information utilisant un tel codage.**

(57) L'installation comprend un circuit de codage comportant un soustracteur algébrique recevant les échantillons du signal à coder et un signal de prédiction. L'unité de quantification (18) est prévue pour affecter à chaque échantillon reçu e(n) le numéro d'ordre de plage pour lequel le signal quantifié e*(n) fourni par le quantificateur inverse est le plus proche de l'échantillon d'entrée e(n).

## Procédé de codage MIC différentiel et installation de transmission d'information utilisant un tel codage

L'invention concerne les procédés de codage temporel (c'est-à-dire cherchant à préserver l'allure temporelle des signaux) à haut débit, et notamment les procédés de codage MIC (modulation par impulsions et codage) utilisés pour numériser des signaux représentant par exemple des messages verbaux, de la musique, des images, en vue de leur transmission ou de leur stockage.

Fondamentalement, le codage MIC, dit aussi PCM, consiste, dans le cas d'une transmission :

à l'émission, à échantillonner le signal à transmettre, à quantifier les échantillons, à les coder sous forme numérique et à les émettre sur un canal de transmission ;

à la réception, à décoder les signaux reçus et à reconstituer le signal d'origine, souvent par transformation numérique/analogique.

On a déjà proposé divers perfectionnements visant à réduire le débit d'informations numériques à transmettre.

On obtient un premier progès en substituant le codage MIC différentiel, ou MICD, au codage MIC simple : au lieu de quantifier le signal d'entrée, on quantifie la différence entre ce signal et un signal de prédiction. Le signal de prédiction est élaboré par un circuit prédicteur dont les paramètres sont renouvelés à chaque échantillonnage par un algorithme utilisant l'évolution du signal de différence quantifié (FR-A-2 471 084 et 2 481 024).

Un second progès consiste, pour mieux utiliser le nombre limité de niveaux disponibles au quantificateur, à diviser le signal de différence par un facteur de gain adaptatif lors du codage, puis à multiplier le signal quantifié par le même facteur pour restituer l'échantillon quantifié définitif au décodage. On trouvera une description de ce principe de quantification dans l'article "A robust adaptive Quantizer" par D. J. GOLDMAN et R/M. WILKINSON, dans la revue "IEEE TRANSACTIONS ON COMMUNICATIONS", Novembre 1975. La mise en oeuvre de ce principe à l'aide d'un processeur de traitement de signal est donnée dans l'article "Adaptive differential pulse - Code modulation coding" par J. R. Bodie et Coll. parue dans la revue américaine "BSTJ", Septembre 1981.

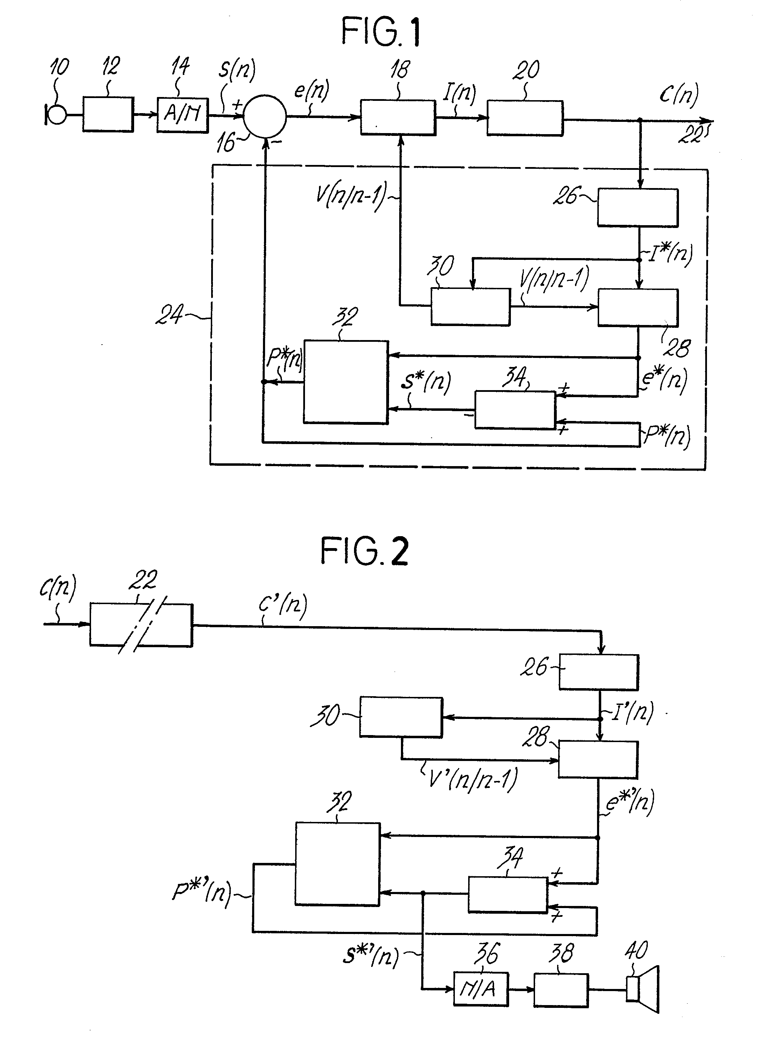

La constitution de principe d'un système mettant en jeu le codage MICD adaptatif, ou MICDA, peut être celle montrée en Figure 1, qui est un schéma synoptique d'un circuit de codage, et en Figure 2, qui est un schéma d'un circuit de décodage associé au premier.

Le circuit de codage montré à titre d'exemple en Figure 1 est destiné à être incorporé à un système de transmission de signaux sonores. Le signal S(n) qu'il reçoit est en conséquence élaboré par un circuit de numérisation comprenant un microphone 10, un filtre anti-repliement 12 et un convertisseur analogique/numérique 14.

Le circuit de codage de la Figure 1 comprend un soustracteur algébrique 16 à deux entrées. La première entrée reçoit le signal S(n) et la seconde un signal de prédiction P*(n). La sortie du soustracteur 16 fournit un signal de différence ou d'erreur e(n) qui est appliqué à l'entrée d'une unité de quantification 18 où va être effectué le codage. L'unité de quantification 18 reçoit un signal V(n) élaboré à chaque instant n en fonction des signaux disponibles à cet instant n. Elle compare chaque échantillon reçu e(n) à des paliers de quantification successifs affectés chacun d'un numéro. Elle réagit à l'application de chaque échantillon en fournissant sur sa sortie le numéro d'ordre I(n) du palier de quantification dans lequel se place l'échantillon. L'unité de quantification attaque un codeur binaire 20 dont la sortie délivre le signal C(n) qui est appliqué au canal de transmission 22 (Figure 2). Le codeur 20 fournit le signal C(n), par exemple sous forme de la valeur absolue et du signe de I(n), du complément à deux de I(n), etc.

Le signal C(n) est également appliqué à un circuit 24 de génération du signal de commande V(n/n-1) dont le rôle apparaîtra plus loin. Pour donner au schéma de la Figure 1 une portée générale, on a représenté, dans le circuit décodeur local 24, un décodeur binaire 26 qui fournit, à partir du signal C(n), une reconstitution I*(n) du signal I. Dans le cas illustré, on aurait pu relier directement la sortie de l'unité de quantification 18 à l'entrée du circuit décodeur local 24. Toutefois, l'introduction du quantificateur inverse dans la boucle permet de réinjecter le bruit de quantification dans le cas où le quantificateur et le quantificateur inverse n'ont pas le même nombre de niveaux ("embedded ADPCM en terminologie anglo-saxonne").

Le signal I*(n) est appliqué, d'une part, à l'entrée d'un quantificateur inverse 28, d'autre part, à l'entrée d'un circuit 30 de génération du signal de commande V(n/n-1).

La sortie de l'unité de quantification inverse 28 est constituée par un signal e*(n) qui est un signal d'erreur reconstituée. Ce signal est appliqué à une première entrée d'un circuit prédicteur adaptatif 32 et à une première entrée d'un additionneur algébrique 34. La sortie du circuit prédicteur adaptatif fournit le signal p*(n) appliqué, d'une part, à la seconde entrée du circuit soustracteur 16 et, d'autre part, à la seconde entrée de l'additionneur algébrique 34, dont la sortie fournit un signal reconstitué S*(n) qui est appliqué à la seconde entrée du circuit prédicteur 32.

4    0201401

On ne décrira pas ici la constitution des divers circuits mentionnés, car elle peut être entièrement classique.

Le circuit de décodage montré en Figure 2 présente une constitution très similaire à celle du circuit décodeur local 24 et les organes correspondants des deux figures sont désignés par le même numéro de référence. Les signaux apparaissant en des points du circuit de la Figure 2 qui correspondent à des points de la Figure 1 portent également la même référence, affectée de l'indice prime. L'entrée du circuit décodeur MICDA de la Figure 2 reçoit un signal C'(n) provenant du canal de transmission 22. Le décodeur d'entrée 26 fournit un signal I'(n) qui est appliqué, d'une part, à l'unité 30 de calcul V'(n/n-1), d'autre part, à l'entrée d'une unité 28 de quantification inverse commandée par le signal V'. La sortie de l'unité 28 fournit un signal e*'(n) qui est appliqué à une première entrée d'un circuit prédicteur adaptatif 32 et à une première entrée d'un circuit additionneur algébrique 34. Le signal de prédiction P*' fourni par le circuit prédicteur adaptatif 32 est appliqué à la seconde entrée de l'additionneur algébrique 34. Le signal de sortie S*'(n) de ce dernier constitue le signal de sortie du circuit décodeur, c'est-à-dire le signal restitué correspondant à S(n). Il est également appliqué à la seconde entrée du circuit prédicteur adaptatif 32.

Le signal restitué S*'(n) doit être mis sous forme de signal sonore : cette fonction est remplie sur la Figure 2 par un convertisseur numérique/analogique 36, un filtre 38 et un transducteur 40.

S'il n'y avait aucune modification du code C(n) par le canal de transmission 22, les signaux désignés par la même référence dans le décodeur local 24 et dans le décodeur de réception de la Figure 2 seraient identiques.

Mais, dans la pratique, les imperfections du canal de transmission sous la forme d'erreurs de transmission modifient le code $C(n)$ transmis en $C'(n)$, ce qui a pour effet de faire disparaître l'identité précédente par l'intermédiaire du décodage.

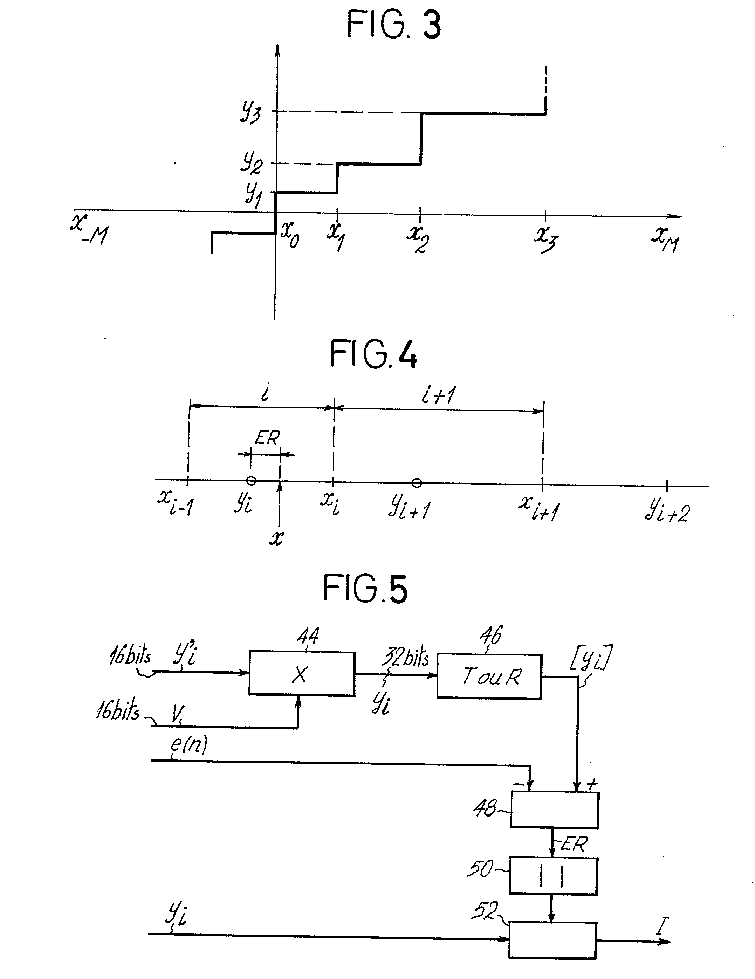

Dans son principe, la quantification consiste à comparer le signal à quantifier $\underline{e}$ à un ensemble de seuils de décision $[X_{-M}, \ldots x_{-1}, x_0, x_1, \ldots x_M]$ représentés au nombre de quatre de chaque signe sur la Figure 3, la valeur absolue des seuils extrêmes étant égale à l'infini. Dans un système adaptatif, les seuils $x_i$ de décision sont variables lorsque la dynamique du signal $\underline{e}$ varie au cours du temps. Ils dépendent de seuils fixes $x'_i$ déterminés une fois pour toutes et de la variable de commande $V(n/n-1)$, proportionnelle à l'écart type du signal. A l'issue de cette comparaison, la quantification affecte à chaque signal d'entrée $\underline{e}$ le numéro $I_i$ d'une plage de décision limitée par deux seuils. Ce numéro $I_i$ fait ensuite l'objet d'un codage donnant naissance à $C(i)$.

Le quantificateur inverse (quantificateur 28 sur la Figure 1) fait correspondre à C un niveau quantifié qu'on va désigner, pour les besoins de l'explication qui suit, par $y_i$ pour la plage de décision de numéro d'ordre $I_i$.

Les seuils de décision variables peuvent notamment être déterminés par simple multiplication :

$$x_i = x'_i \cdot V(n/n-1)$$

et, de façon similaire, la quantification inverse va donner naissance à un signal d'erreur quantifié $y_i$ (correspondant à $e*(n)$ sur la Figure 1) :

$$y_i = y'_i \cdot V(n/n-1)$$

où $y'_i$ est le niveau de quantification fixe correspondant au numéro d'ordre $I*_i$, $I_i$ ou $I'_i$ au décodeur.

Dans le dispositif suivant l'art antérieur, la quantification fait habituellement correspondre, au

signal d'entrée $\underline{e}$ à l'instant $\underline{n}$, le numéro d'ordre $I(n)$ = $I_i$ de la plage de décision tel que :

$$x_{i-1} < e(n) < x_i.$$

les valeurs de $\underline{x}$ intervenant dans cette formule étant élaborées à partir des valeurs fixes $x'_i$.

Il existe diverses tables de valeurs $x'_i$, établies à partir d'études d'optimisation. On peut notamment citer celle fournie par J. MAX dans l'article "Quantizing for minimum distorsion" publié dans "IRE TRANSACTIONS ON INFORMATION THEORY", Mars 1960 et celles de M. D. PAEZ et T. H. GLISSON dans "IEEE Transactions on Communications", Avril 1972. Les valeurs de $x'_i$ correspondant à cette dernière référence, pour une quantification à trente-deux niveaux, sont données dans la première colonne du tableau I auquel il sera fait référence plus loin.

Dans le cas envisagé ici, la quantification inverse, assurée par le circuit 28 sur la Figure 1 ou 2, transforme le signal reçu I* ou I' en un signal d'erreur quantifié e* ou e*'.

Dans les dispositifs suivant l'art antérieur, la valeur $V(n/n-1)$ à l'instant $\underline{n}$ est déterminée en fonction de sa valeur à l'instant précédent $V(n-1/n-2)$ et du numéro $I(n-1)$ de la plage correspondant au signal e*(n-1) à l'instant n-1, par le circuit de génération 30 dans le codeur et dans le décodeur. Cette élaboration peut s'effectuer suivant la méthode décrite dans la communication "A robust adaptive quantizer" déjà mentionnée.

Jusqu'à présent, il a été supposé que les nombres étaient représentés en précision illimitée. Dans la réalité, les nombres ne sont représentés qu'au moyen d'un nombre de bits déterminé et fini, soit en virgule flottante (c'est-à-dire avec mantisse et exposant, ce qui fournit une précision pratiquement illimitée, sauf si la limitation du nombre de bits est excessive), soit en virgule fixe, c'est-à-dire avec une partie entière et une partie fractionnaire.

En virgule fixe, et souvent en virgule flottante, les multiplications qui interviennent pour déterminer $x_i$ et $y_i$ à partir de $x'_i$ et de $y'_i$ font apparaître des erreurs de calcul. On écrira :

$$x_i = [x'_i \cdot V]$$
$$y_i = [y'_i \cdot V]$$

pour indiquer le passage en précision finie, en affectant l'indice R au passage en précision finie par voie d'arrondi et T au passage par voie de troncature.

Du fait que la quantification adaptative suivant l'art antérieur dissocie complètement la quantification directe et la quantification inverse, ces deux opérations en séquence, nécessaires pour réaliser la quantification complète, ne tiennent pas compte de l'erreur d'arrondi ou de troncature qui intervient dans la multiplication en précision finie du quantificateur inverse. Le tableau I donne, à titre d'exemples, les valeurs de $x'_i$ et $y'_i$ ainsi que les valeurs de $x_i$ et $y_i$ pour $V(n/n-1) = 16$ et les niveaux quantifiés $[]_T$ après troncature, $[]_R$ après arrondi. Ces valeurs sont celles données dans la communication "Minimum mean squared error quantization in speech PCM and DPCM systems" par M.D. Paez et T. H. Glisson dans "IEEE TRANSACTIONS ON COMMUNICATIONS", Avril 1972. Le tableau I montre également les valeurs de y' restitué dans le cas de la troncature et dans le cas de l'arrondi, toujours avec une variable de commande V égale à 16.

| Indice $i$ | $x'_i$ | Seuils de décision $x'_i \times 16$ | Valeur tronquée $[x'_i \times 16]T = x_i$ | Valeur arrondie $[x'_i \times 16]R = x_i$ |
|---|---|---|---|---|
| 0 | 0 | 0 | 0 | 0 |
| 1 | 0,02900 | 0,464 | 0 | 0 |
| 2 | 0,05958 | 0,9532 | 0 | 1 |
| 3 | 0,09213 | 1,474 | 1 | 1 |
| 4 | 0,12665 | 2,0264 | 2 | 2 |
| 5 | 0,16354 | 2,6167 | 2 | 3 |
| 6 | 0,20339 | 3,2542 | 3 | 3 |
| 7 | 0,24 66 | 3,9455 | 3 | 4 |
| 8 | 0,29394 | 4,7030 | 4 | 5 |
| 9 | 0,34642 | 5,5427 | 5 | 6 |
| 10 | 0,40540 | 6,4865 | 6 | 6 |
| 11 | 0,47307 | 7,5691 | 7 | 8 |
| 12 | 0,55317 | 8,8507 | 8 | 9 |
| 13 | 0,65200 | 10,432 | 10 | 10 |
| 14 | 0,78477 | 12,5563 | 12 | 13 |
| 15 | 1 | 16 | 16 | 16 |
| 16 | | | | |

| N° plage à transmettre $i$ | $y'_i$ | Quantification inverse $y'_i \times 16$ | $[y'_i \times 16]T = y_i$ | $[y'_i \times 16]R = y_i$ |
|---|---|---|---|---|
| 1 | 0,01420 | 0,2272 | 0 | 0 |
| 2 | 0,04379 | 0,7007 | 0 | 1 |
| 3 | 0,07536 | 1,2057 | 1 | 1 |
| 4 | 0,10870 | 1,7392 | 1 | 2 |
| 5 | 0,14441 | 2,3105 | 2 | 2 |
| 6 | 0,18268 | 2,9229 | 2 | 3 |
| 7 | 0,22411 | 3,5858 | 3 | 4 |
| 8 | 0,26928 | 4,3085 | 4 | 4 |
| 9 | 0,31880 | 5,1008 | 5 | 5 |
| 10 | 0,37404 | 5,9846 | 5 | 6 |
| 11 | 0,43677 | 6,9884 | 6 | 7 |
| 12 | 0,50957 | 8,1531 | 8 | 8 |
| 13 | 0,59678 | 9,5482 | 9 | 10 |
| 14 | 0,70743 | 11,319 | 11 | 11 |
| 15 | 0,8623 | 13,7968 | 13 | 14 |
| 16 | 1,13789 | 18,206 | 18 | 18 |

TABLEAU I

Les erreurs de restitution provoquées par la mise en oeuvre des procédés connus de codage MICDA deviennent extrêmement graves lorsque plusieurs systèmes de quantification complète travaillant en précision finie sont implantés en cascade. En effet, les dégradations s'accumulent alors. Or, la structure de beaucoup de réseaux de transmission fait que plusieurs systèmes peuvent être placés en cascade. Ce sera en particulier le cas du futur réseau d'audioconférence.

L'invention vise notamment à réduire la dégradation provoquée par la mise en cascade de plusieurs ensembles de codage complet travaillant en précision limitée et ayant en conséquence des erreurs d'arrondi ou de troncature. Dans ce but, l'invention propose d'introduire l'opération de quantification inverse dans le dispositif assurant la quantification, en substituant au mode classique d'affectation d'un numéro I de plage, un texte de proximité effectué sur les valeurs de $\underline{y}$ adjacentes à la valeur de $\underline{x}$.

De façon plus précise l'invention propose un procédé de codage MICDA de signaux présentant une corrélation entre échantillons successifs, suivant lequel, à l'émission, on échantillonne le signal à transmettre, on détermine la différence entre les échantillons successifs et un signal de prédiction élaboré par un algorithme utilisant l'évolution du signal de différence quantifié, et on code le signal de différence sous forme numérique et, à la réception, on décode les signaux reçus et on reconstitue le signal d'origine pour restituer l'échantillon quantifié, caractérisé en ce qu'on affecte à chaque échantillon quantifié le numéro d'ordre de la plage de quantification associé au niveau de quantification le plus proche lors de la quantification inverse au décodage.

Le tableau II ci-après donne, à titre d'exemple, une comparaison entre les résultats obtenus par mise en oeuvre de l'invention et les résultats correspondant à la mise en oeuvre d'un procédé suivant l'art antérieur, dans les conditions du tableau I.

TABLEAU II

**Première Opération**

| | 0 | 1 | 2 | 3 | 4 | 5 | 6 | 7 | 8 | 9 | 10 | 11 | 12 | 13 | 14 |
|---|---|---|---|---|---|---|---|---|---|---|---|---|---|---|---|
| $e(n)$ | 0 | 1 | 2 | 3 | 4 | 5 | 6 | 7 | 8 | 9 | 10 | 11 | 12 | 13 | 14 |
| $\overline{e}(n)_T$ | 0 | 1 | 2 | 3 | 5 | 5 | 6 | 8 | 9 | 9 | 11 | 11 | 13 | 13 | 13 |
| $\overline{e}(n)_R$ | 0 | 1 | 2 | 3 | 4 | 5 | 6 | 7 | 8 | 10 | 11 | 11 | 11 | 14 | 14 |
| $\overline{c}(n)_{IN}$ | 0 | 1 | 2 | 3 | 4 | 5 | 6 | 7 | 8 | 10 | 10 | 11 | 11 | 14 | 14 |

CODAGE ET QUANTIFICATION

**Deuxième Opération**

| | 0 | 1 | 2 | 3 | 4 | 5 | 6 | 7 | 8 | 9 | 10 | 11 | 12 | 13 | 14 |
|---|---|---|---|---|---|---|---|---|---|---|---|---|---|---|---|
| $\overline{e}_2(n)_T$ | 0 | 1 | 2 | 3 | 5 | 5 | 6 | 9 | 9 | 9 | 11 | 11 | 13 | 13 | 13 |
| $\overline{e}_2(n)_R$ | 0 | 1 | 2 | 3 | 4 | 5 | 6 | 7 | 8 | 11 | 11 | 11 | 11 | 14 | 14 |
| $\overline{e}_2(n)_{IN}$ | 0 | 1 | 2 | 3 | 4 | 5 | 6 | 7 | 8 | 10 | 10 | 11 | 11 | 14 | 14 |

Sur le tableau II, e(n) désigne les nombres à quantifier, de 0 à 14. Les valeurs quantifiées obtenues à l'issue d'une première quantification complète sont données dans le cas de l'art antérieur avec troncature et avec arrondi, ainsi que le résultat é*(n)$_{IN}$ de l'invention. Dans le tableau, les erreurs de restitution (nombre quantifié différent du nombre à coder) sont indiquées par les chiffres soulignés. On constate que, lors de la première quantification complète, le procédé suivant l'art antérieur conduit à quatre erreurs dans le cas de l'arrondi et six erreurs dans le cas de la troncature. L'invention limite les erreurs à trois.

L'intérêt de l'invention apparaît surtout lorsque plusieurs quantifications complètes interviennent en cascade. En effet, alors que chacune des quantifications ultérieures se traduit par des erreurs supplémentaires dans le cas de l'art antérieur, chaque nouveau codage suivant l'invention ne provoque pas de dégradation supplémentaire.

L'amélioration apportée par l'invention est particulièrement importante pour les valeurs faibles de la variable de commande V(n/n-1) pour lesquelles des erreurs d'arrondi et de troncature de l'ordre de l'erreur de quantification en précision illimitée sont obtenues, et ce d'autant plus facilement que la quantification s'effectue sur un grand nombre de niveaux. En effet, le silence donne une imprécision d'autant plus importante que ce convertisseur présente moins de niveaux.

A titre d'exemple, on peut indiquer que, sur un ensemble de seize phrases prononcées par des locuteurs, la substitution du procédé de quantification complète suivant l'invention à un procédé antérieur dans un codeur MICDA à 64 kbits/s apporte un gain de l'ordre de 2dB sur le rapport signal à bruit segmentaire. Un deuxième codage-décodage suivant l'art antérieur apporte une dégradation supplémentaire de l'ordre de 2 dB. L'introduction du procédé de quantification suivant l'invention permet d'annuler totalement cette dégradation.

En résumé, d'une part, l'invention permet d'éviter toute dégradation du rapport signal à bruit après le premier codage-décodage, d'autre part, améliore les résultats des premiers codages/décodages surtout dans le cas de valeurs faibles de la variable de commande.

L'invention propose également un dispositif permettant de mettre en oeuvre le procédé ci-dessus défini, comportant un circuit de codage comportant un soustracteur algébrique recevant les échantillons du signal à coder et un signal de prédiction, une unité de quantification destinée à faire correspondre à chaque échantillon de sortie du soustracteur le numéro d'ordre $I(n)$ d'une plage de quantification, une unité de quantification inverse restituant un signal quantifié $e^*(n)$ à un prédicteur fournissant ledit signal de prédiction, caractérisé en ce que l'unité de quantification est prévue pour affecter à chaque échantillon reçu $e(n)$ le numéro d'ordre de plage pour lequel le signal quantifié $e^*(n)$ fourni par le quantificateur inverse est le plus proche de l'échantillon d'entrée $e(n)$.

L'invention sera mieux comprise à la lecture de la description qui suit de modes particuliers de réalisation, donnés à titre d'exemples non limitatifs. La description se réfère aux dessins qui l'accompagnent, dans lesquels :

- les Figures 1 et 2, déjà mentionnées, sont des schémas synoptiques de principe d'un codeur et d'un décodeur MICDA de type connu ;

- la Figure 3 est un diagramme montrant un mode de quantification connu, couramment utilisé dans un codeur du genre montré en Figure 1 ;

- la Figure 4 est un schéma montrant le principe de mise en oeuvre de l'invention ;

- la Figure 5 est un schéma synoptique de principe montrant une constitution possible d'un circuit utilisable pour mettre en oeuvre l'invention dans le codeur de la Figure 1 ;

- la Figure 6 est un organigramme explicitant un premier mode de mise en oeuvre du procédé de quantification suivant l'invention ;

- la Figure 7, similaire à la Figure 6, montre une variante.

Le principe de mise en oeuvre de l'invention apparaît sur la Figure 4. Sur cette Figure apparaissent les plages de décision i et i+1, limitées respectivement par les seuils de décision $x_{i-1}$ et $x_i$ d'une part, $x_i$ et $x_{i+1}$ d'autre part. Les seuils de décision sont situés chacun au milieu de l'intervalle séparant deux niveaux quantifiés successifs, par exemple $y_i$ et $y_{i+1}$ pour le seuil $x_i$.

Et, comme dans le cas de procédés traditionnels, on détermine, pour chaque plage de décision, un signal de sortie correspondant à un palier de quantification :

$$y_i = y'_i . V(n/n-1)$$

Comme dans le cas traditionnel, on se trouve face au problème que la multiplication des deux nombres $y'_i$ et $V$ conduit à un nombre $y_i$ dont la représentation nécessiterait normalement plus d'éléments binaires que l'un quelconque des deux nombres à multiplier et qu'on est amené à passer en précision finie par une troncature ou un arrondi qui conduit à :

$$y^*_i = [y_i]_R \text{ ou } [y_i]_T .$$

Le numéro d'ordre de plage I est ensuite déterminé.

Conformément à l'invention, le numéro d'ordre I affecté est tel que :

$$|e(n) - Y^*_I| = \underset{i = 1, \ldots, N}{\text{Min}} \left\{ |e(n) - y^*_i| \right\}$$

où e(n) est le signal à quantifier.

La formule ci-dessus représente un test de proximité. On affecte à $\underline{e}$ le numéro d'ordre I qui correspond au niveau quantifié le plus proche. Cela revient à prendre en compte la précision finie sur la quantification inverse dans le processus de quantification directe.

Les modifications qu'il est nécessaire d'apporter, pour mettre en oeuvre l'invention, à un dispositif classique du genre montré en Figure 1, portent essentiellement sur le quantificateur. Dans le cas montré en Figure 5, il comporte, de façon classique, un multiplieur 44 travaillant par exemple sur seize bits en entrée. La sortie du multiplieur, de trente-deux bits, est ramenée à seize bits par un circuit 46 de troncature ou d'arrondi. Le nombre $[y_i]$ qui en résulte est appliqué à un soustracteur qui reçoit le signal d'entrée e(n) du quantificateur. Le soustracteur 48 fournit en sortie les écarts ER entre les valeurs de $y_i$ en précision finie et $\underline{e}$, et notamment la valeur ER indiquée en Figure 4. Un circuit 50 fournit la valeur absolue des écarts et un circuit 52 détermine la valeur de $y_i$ correspondant au minimum permettant ainsi d'obtenir I.

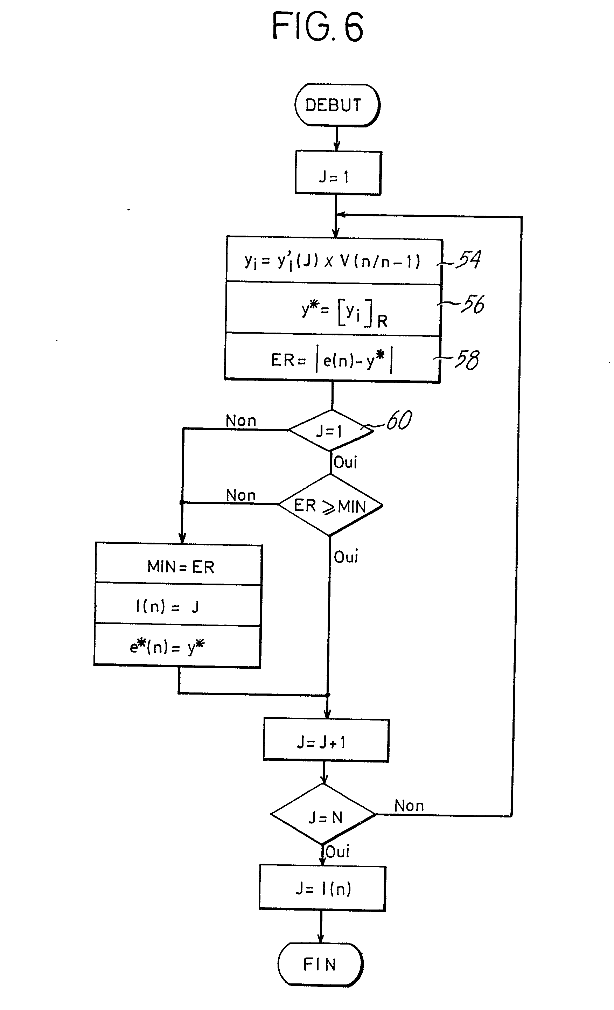

Dans la pratique, les circuits 50 et 52 peuvent être combinés dans une unité de calcul. La Figure 6 montre un premier organigramme qui peut être utilisée pour le fonctionnement de l'unité de calcul. Cet organigramme peut sans difficulté être implémenté sur une calculatrice de modèle courant, par exemple NEC 7720 ou unité centrale d'un PDP 11 (DIGITAL).

L'élément essentiel de l'organigramme est constitué par une boucle de calcul qui est parcourue jusqu'à ce que la valeur de y* correspondant à une valeur minimum de ER ait été trouvée.

Le parcours de la boucle s'effectue par incrémentation d'un indice J et pour chaque valeur de J on compare l'écart ER à la valeur minimum précédemment trouvée. En pratique, on détecte le signe du signal et on quantifie sa valeur absolue. On réintroduit le repère en sortie du quantificateur inverse.

L'organigramme de la Figure 6 étant très simple ne sera que sommairement décrit : la première opération consiste à déterminer la valeur quantifiée de $\underline{v}$ pour J = 1 (cadre 54). V(n/n-1) est la variable de commande en sortie de l'adaptateur 30. Le calcul en précision illimitée est suivi d'une troncature en 56, puis du calcul de la valeur absolue de l'écart ER en 58. Un premier test 60 permet de stocker la première valeur calculée de ER en tant que minimum provisoire MIN, J en tant que valeur provisoire du numéro de plage, et y* en tant que e*(n). y* est initialement la valeur disponible, obtenue à partir d'un décodeur local éventuel.

Une fois le calcul effectué pour J = 1, la boucle est parcourue jusqu'à atteindre J = N, c'est-à-dire pour tous les niveaux de quantification successifs. A l'issue de cette opération, la valeur J = I(n) correspond au minimum de ER est retenue.

L'organigramme de la Figure 6 présente l'inconvénient d'obliger à explorer tous les niveaux de quantification pour déterminer une valeur minimale d'écart. Il pourrait être modifié de façon à arrêter l'exploration dès que ER cesse de décroître pour augmenter, ce qui implique un test supplémentaire.

Une autre solution permettant de réduire le nombre de tests d'exploration consiste à effectuer une quantification par dichotomie à partir des niveaux quantifiés. On se place tout d'abord au niveau i = N/2 puis, à chaque étape de l'itération, on réduit le pas de modification de $\underline{i}$ par 2. Lorsque le nombre de niveaux de quantification est élevé, le volume de calcul est notablement diminué.

En résumé, cette approche consiste, si on est parti du niveau N/2, à explorer ensuite les niveaux N/2 + N/4 ou N/2 - N/4 suivant que $e$ est supérieur ou inférieur à N/2, et ainsi de suite.

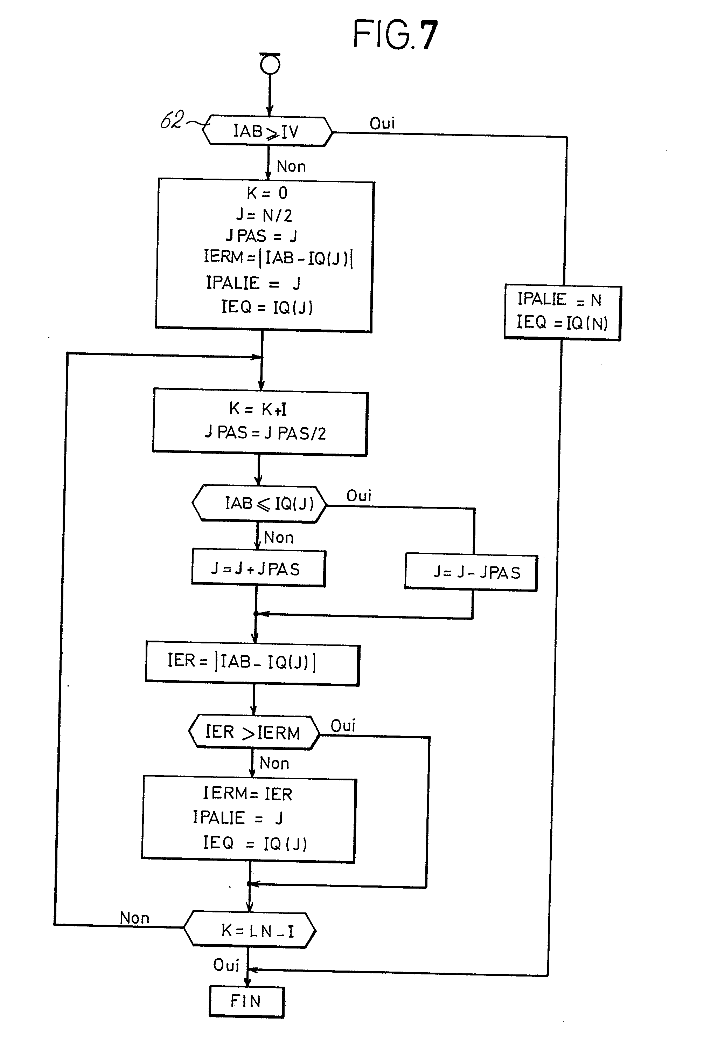

L'organigramme montré en Figure 7 correspond à cette approche. Il n'est pas nécessaire d'en donner ici une description, étant donné sa simplicité. Il suffit de noter que les notations sont les suivantes :

IAB       valeur absolue du signal à quantifier

N         nombre de paliers positifs du quantificateur

K         indice de l'itération

LN        nombre d'étapes de la dichotomie (Log $_2$ N)

J         indice de palier

JPAS      pas d'exploration

IQ(J)     J = 1,... N, niveaux quantifiés calculés par 54, 56 et 58

IER       erreur de quantification à l'étape K

IERM      erreur de quantification minimale après K étapes

IPALIE    palier correspondant à IERM

IEQ       valeur quantifiée correspondant à IPALIE

IV        seuil de saturation (sortie de l'adaptateur 30)

Il faut remarquer que l'organigramme de la Figure 7 ne permet pas d'atteindre le niveau N. Pour cette raison, il comprend un test de saturation 62 qui permet de déterminer préalablement s'il y a une saturation positive ou négative, auquel cas on passe directement en fin de boucle.

Un dispositif du genre montré en Figure 7 est susceptible de fonctionner à un débit de 8 kHz pour un débit de transmission de 32 kbits/s. Cet organigramme pourra être modifié pour l'adapter au mieux au jeu d'instructions et à la structure du processeur spécifique utilisé pour la mise en oeuvre. Par ailleurs, on peut écarter le test de saturation initial à condition

0201401

d'effectuer un contrôle sur les valeurs extrêmes. Il n'est pas nécessaire de décrire ici de façon détaillée l'organigramme correspondant, qui découle directement de celui qui précède mais est légèrement plus complexe.

## REVENDICATIONS

1. Procédé de codage MICDA de signaux présentant une corrélation entre échantillons successifs, suivant lequel, à l'émission, on échantillonne le signal à transmettre, on détermine la différence entre les échantillons successifs et un signal de prédiction élaboré par un algorithme utilisant l'évolution du signal de différence quantifié, et on code le signal de différence sous forme numérique et, à la réception, on décode les signaux reçus et on reconstitue le signal d'origine pour restituer l'échantillon quantifié,

caractérisé en ce qu'on affecte à chaque échantillon quantifié le numéro d'ordre de la plage de quantification associé au niveau de quantification le plus proche lors de la quantification inverse au décodage.

2. Procédé selon la revendication 1, caractérisé en ce que le numéro d'ordre I de plage affecté à un échantillon e(n) est tel que :

$$|e(n) - Y^*_I| = \text{Min} \left\{ |e(n) - y^*_i| \right\}$$

dans laquelle $y^*_i$ est le niveau de quantification affecté lors de la quantification inverse.

3. Procédé selon la revendication 1 ou 2, caractérisé en ce que la détermination du numéro d'ordre I s'effectue par comparaison de l'échantillon avec tous les niveaux de quantification successifs.

4. Procédé selon la revendication 1 ou 2, caractérisé en ce que la comparaison est effectuée sur les niveaux de quantification en séquence jusqu'à ce que l'écart en valeur absolue entre échantillon et valeur de quantification cesse de décroître pour augmenter.

5. Procédé selon la revendication 1 ou 2, caractérisé en ce que le numéro d'ordre de plage est déterminé par dichotomie à partir du niveau médian, le pas de modification du numéro d'ordre étant divisé par deux à chaque étape d'itération.

6.    Installation de transmission d'information à codage MICDA comprenant un circuit de codage comportant un soustracteur algébrique recevant les échantillons du signal à coder et un signal de prédiction, une unité de quantification (18) destinée à faire correspondre à chaque échantillon de sortie du soustracteur le numéro d'ordre I(n) d'une plage de quantification, une unité de quantification inverse (28) restituant un signal quantifié e*(n) à un prédicteur fournissant ledit signal de prédiction, caractérisé en ce que l'unité de quantification (18) est prévue pour affecter à chaque échantillon reçu e(n) le numéro d'ordre de plage pour lequel le signal quantifié e*(n) fourni par le quantificateur inverse est le plus proche de l'échantillon d'entrée e(n).

FIG.1

FIG.2

## FIG. 3

## FIG. 4

## FIG. 5

3/4

0201401

# FIG.6

DEBUT

$J = 1$

$y_i = y'_i(J) \times V(n/n-1)$ — 54

$y^* = \left[y_i\right]_R$ — 56

$ER = \left|e(n) - y^*\right|$ — 58

$J = 1$ — 60

Non / Oui

$ER \geqslant MIN$

Non / Oui

$MIN = ER$

$I(n) = J$

$e^*(n) = y^*$

$J = J + 1$

$J = N$

Non / Oui

$J = I(n)$

FIN

# FIG.7

62 — IAB ≥ IV — Oui

Non

```
K = 0
J = N/2
JPAS = J
IERM = │IAB - IQ(J)│
IPALIE = J
IEQ = IQ(J)
```

```
IPALIE = N
IEQ = IQ(N)
```

```
K = K+I
JPAS = JPAS/2
```

IAB ≤ IQ(J) — Oui

Non

J = J + JPAS

J = J - JPAS

IER = │IAB - IQ(J)│

IER > IERM — Oui

Non

```
IERM = IER
IPALIE = J
IEQ = IQ(J)
```

Non — K = LN_I

Oui

FIN

Office européen
des brevets

**RAPPORT DE RECHERCHE EUROPEENNE**

0201401
Numéro de la demande

EP 86 40 0888

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IEEE TRANSACTIONS ON COMMUNICATIONS, vol. COM-23, no. 9, septembre 1975, pages 935-941, IEEE, New York, US; COHN et al.: "The residual encoder - An improved ADPCM system for speech digitization" * Page 937, colonne de gauche, dernier alinéa - colonne de droite, ligne 11 * | 1,2 | H 03 M 3/04 |
| | --- | | |
| A | GB-A-2 131 637 (NTT) * Page 3, lignes 49-120 * | 1 | |
| | ----- | | |

**DOMAINES TECHNIQUES RECHERCHES (Int. Cl.4)**

H 03 M
H 04 B

Le présent rapport de recherche a été établi pour toutes les revendications

| Lieu de la recherche | Date d'achèvement de la recherche | Examinateur |
|---|---|---|
| LA HAYE | 04-08-1986 | HOLPER G.E.E. |